# EUROPEAN PATENT APPLICATION

(11) **EP 4 753 437 A2**
(43) Date of publication of application: **03.06.2026**
(21) Application number: 25211712.2
(22) Date of filing: 28.10.2025
(51) Int. Cl.: H10W 10/00, H10W 10/10, H10W 10/17, H10W 15/00

(54) **HV BCD TECHNOLOGY WITH DTI STRUCTURES**

(30) Priority: 25.11.2024 US 202418958301
(71) Applicant: NXP USA, Inc., Austin, TX 78735 (US)
(72) Inventor: Zhang, Zhihong, 5656 AG Eindhoven (NL); Zhu, Ronghua, 5656 AG Eindhoven (NL); Lin, Xin, 5656 AG Eindhoven (NL); Mehrotra, Saumitra Raj, 5656 AG Eindhoven (NL); Roggenbauer, Todd, 5656 AG Eindhoven (NL); van Noort, Wibo Daniel, 5656 AG Eindhoven (NL)
(74) Representative: Schmütz, Christian Klaus Johannes

(57) **Abstract**

An integrated circuit is disclosed which includes a stacked P+ substrate, n-type epitaxial layer, and one or more p-type epitaxial layers, with a buried layer located in the one or more p-type epitaxial layers to be adjacent to the n-type epitaxial layer, a central isolated region located in the one or more p-type epitaxial layers to be positioned over the buried layer, one or more concentric shallow isolation ring structures positioned to surround the central isolated region and to extend down through the buried layer and into the n-type epitaxial layer, and a concentric deep poly isolation structure positioned to surround the central isolated region and the one or more concentric shallow isolation ring structures and to extend down through the n-type epitaxial layer and into the P+ substrate, wherein the concentric deep poly isolation structure include one or more polysilicon layers that are shorted to the P+ substrate.

## Description

### BACKGROUND OF THE INVENTION

### Field of the Invention

The present disclosure is directed in general to the field of semiconductor devices. In one aspect, the present disclosure relates to integrated circuit devices and processes for integrating analog components, digital components and high voltage devices into a single chip or integrated circuit.

### Description of the Related Art

Electronic devices, especially semiconductor devices and integrated circuits, often include multiple, separate semiconductor-based components fabricated on the same semiconductor substrate or die. The components are typically designed to operate independently from one another so that they do not interfere or latch up with neighboring components. To provide electrical isolation between different components, deep trench isolation (DTI) structures and/or high voltage regions may be used in semiconductor devices to electrically isolate laterally and vertically adjacent regions of a substrate. In addition, trench-based isolation techniques are used with silicon-on-insulator wafers to eliminate latch up risk. However, as the operating voltage and component density (components per unit area) on the substrate increase, it becomes increasingly difficult to maintain the desired isolation breakdown voltage. In addition, with shrinking device sizes, junction-based isolation techniques require too much silicon area, and trench-based isolation techniques on SOI wafers are too expensive. And with increased packing density of semiconductor components, there are wider variations in the distribution of breakdown voltages observed across a die or wafer which can lead to lower manufacturing yields. While Bipolar-CMOS-DMOS (BCD) fabrication processes have been developed to combine the strengths of three different process technologies onto a single chip with a shared bulk semiconductor substrate, there continue challenges for protecting the different types of devices, especially with high voltage (e.g., over 100V) applications, including but not limited to high voltage isolation requirements, high holding voltages, isolation breakdown voltage stability, substrate minority carrier injections, DTI process complexity, thick sidewall oxide requirements, etc. As seen from the foregoing, the existing solutions for providing isolation between different or neighboring devices formed on a shared high voltage BCD substrate are extremely difficult at a practical level by virtue of the challenges with providing effective isolation structures while meeting the performance requirements and cost constraints for mass production of semiconductor devices and avoiding the performance and reliability related problems associated with conventional isolation structures.

### BRIEF DESCRIPTION OF THE DRAWINGS

The present disclosure may be understood, and its numerous objects, features and advantages obtained, when the following detailed description of a preferred embodiment is considered in conjunction with the following drawings.
Figure 1 depicts a simplified cross-sectional view of an integrated circuit employing a prior art isolation structure wherein a conductive buried layer intersects with a poly-filled deep trench ring which extends to a p-type epitaxial layer.
Figure 2 depicts a simplified cross-sectional view of an integrated circuit employing a prior art isolation structure wherein a conductive buried layer intersects with concentric poly-filled deep trench rings which extend to a p-type epitaxial layer.
Figure 3 depicts a simplified cross-sectional view of an integrated circuit employing a prior art isolation structure wherein a conductive buried layer intersects with a poly-filled deep trench ring which extends to a p+ substrate layer.
Figure 4 depicts a simplified cross-sectional view of an integrated circuit employing a prior art isolation structure wherein a conductive buried layer intersects with concentric poly-filled deep trench rings which extend to a p- substrate layer.
Figure 5A depicts a simplified cross-sectional view of an integrated circuit employing a double deep trench isolation (DTI) structure formed with two concentric poly-filled deep trench rings, including a deep outer DTI structure extending down through an N-epi layer to a P+ substrate layer in accordance with selected embodiments of the present disclosure.
Figure 5B depicts a simplified plan view of the integrated circuit shown in Figure 5A in accordance with selected embodiments of the present disclosure.
Figure 6A depicts a simplified cross-sectional view of an integrated circuit employing a triple DTI structure formed with three concentric poly-filled deep trench rings, including a deep outer DTI structure extending down through an N-epi layer to a P+ substrate layer in accordance with selected embodiments of the present disclosure.
Figure 6B depicts a simplified plan view of the integrated circuit shown in Figure 6A in accordance with selected embodiments of the present disclosure.
Figure 7A depicts a simplified cross-sectional view of an integrated circuit employing a triple DTI structure formed with three concentric poly-filled deep trench rings, including a deep outer DTI structure extending down through an N-epi layer to a P+ substrate layer and a conductive metal interconnect for connecting the shallow inner DTI structures to a reference voltage in accordance with selected embodiments of the present disclosure.
Figure 7B depicts a simplified plan view of the integrated circuit shown in Figure 7A in accordance with selected embodiments of the present disclosure.
Figure 8 depicts a simulated plot of breakdown voltages as a function of the shallower DTI structure depth for purposes of evaluating different isolation structures.
Figure 9 depicts a simplified flow chart showing the process flow for fabricating a high voltage tub having concentric deep and shallow DTI structures to protect an inner N-well region of high voltage device area in accordance with selected embodiments of the present disclosure.

### DETAILED DESCRIPTION

A method and apparatus are described for fabricating integrated semiconductor devices with high voltage tubs or regions surrounded and protected by multiple concentric deep trench isolation rings, at least one of which is shorted to an underlying P+ substrate layer by extending down past a conductive buried layer and through an N-epi layer to the P+ substrate layer, thereby meeting voltage and isolation requirements for a high voltage bulk technology. As disclosed, the integrated semiconductor devices include a substrate layer of a first conductivity type, a first epitaxial layer of a second conductivity type located on the substrate layer, a conductive buried layer of the second conductivity type located on the first epitaxial layer, an isolated conductive well region formed in one more second epitaxial layers of the first conductivity type located over the conductive buried layer, a first poly isolation trench ring that is shorted to the substrate layer and positioned to surround the isolated conductive well region, and one or more isolation trench rings concentrically located inside the first poly isolation trench ring and positioned to surround the isolated conductive well region, where the one or more isolation trench rings extend down to, but not through, the first epitaxial layer. In selected embodiments, the one or more isolation trench rings are each formed with one or more insulating layers filling a deep trench ring. In other selected embodiments, the one or more isolation trench rings are each formed with an insulating layer of oxide surrounding one or more polysilicon layers. In other selected embodiments, each of the one or more isolation trench rings is formed with an insulating layer of oxide surrounding one or more polysilicon layers connected to a predetermined voltage.

Various illustrative embodiments will now be described in detail with reference to the accompanying figures. As described hereinbelow, the disclosed embodiments can be arranged and designed in a wide variety of different configurations. Thus, the following detailed description of various embodiments, as represented in the figures, is not intended to limit the scope of the present disclosure, but is merely representative of various embodiments. While various details are set forth in the following description, it will be appreciated that the present invention may be practiced without these specific details, and that numerous implementation-specific decisions may be made to the invention described herein to achieve the device designer's specific goals, such as compliance with process technology or design-related constraints, which will vary from one implementation to another. While such a development effort might be complex and time-consuming, it would nevertheless be a routine undertaking for those of ordinary skill in the art having the benefit of this disclosure. In addition, the various aspects of the embodiments are presented in drawings that are not necessarily drawn to scale unless specifically indicated. Furthermore, the described features, advantages, and characteristics of the invention may be combined in any suitable manner in one or more embodiments. One skilled in the relevant art will recognize, in light of the description herein, that the embodiments can be practiced without one or more of the specific features or advantages of a particular embodiment. In other instances, additional features and advantages may be recognized in certain embodiments that may not be present in all embodiments. For example, selected aspects are depicted with reference to simplified cross sectional drawings of a semiconductor device without including every device feature or geometry in order to avoid limiting or obscuring the present invention. It is also noted that, throughout this detailed description, certain materials will be formed and removed to fabricate the semiconductor structure. Where the specific procedures for forming or removing such materials are not detailed below, conventional techniques to one skilled in the art for growing, depositing, removing or otherwise forming such layers at appropriate thicknesses shall be intended. Such details are well known and not considered necessary to teach one skilled in the art of how to make or use the present invention.

As will be appreciated by those skilled in the art, semiconductor-based electronic devices are typically formed with a single substrate in which is formed a number of independent semiconductor components, such as bipolar devices, complementary MOS (CMOS) devices, and/or double diffusion (DMOS) devices (collectively, BCD devices). To ensure that each semiconductor component operates correctly, the semiconductor components are electrically isolated from one another and from the substrate using one or more isolation structures so that each component type may be formed within an isolated region of the isolation structure. For each isolation structure, lateral isolation of the isolated region is often achieved by encircling the isolated region with an insulative trench structure configured to inhibit lateral current flow from one component on the substrate to the next. Vertical isolation is achieved using junction isolation between the isolated region and the substrate. The degree to which each component is electrically isolated from surrounding components and substrate affects the maximum voltage at which the semiconductor device can operate.

The isolation voltage capability (a.k.a., breakdown voltage) of a particular isolation structure refers to the maximum voltage that an isolated region of the isolation structure may be exposed to without affecting the operation of other semiconductor components formed over the same substrate in a way that is detrimental to the operation of the entire electronic device. If the voltage of the isolated region is too great, some amount of current significantly exceeding a normal leakage current begins to flow from the isolated region to other isolated regions or the substrate, and this can cause the components in other isolated regions to malfunction and/or may cause significant power consumption or even burning of the overall device. This current, sometimes referred to as crosstalk, limits the maximum voltage that may be utilized by the device, thereby limiting the capabilities of the individual semiconductor components.

Within a particular semiconductor device, a number of factors can operate to reduce the isolation breakdown voltage of a particular isolation structure. First, as the number of components formed over a single substrate increases, the density of the individual semiconductor components on the substrate also increases, and this, in turn increases the density of isolation trenches formed around the components. With isolation trenches typically being formed with an oxide or insulator liner layer that is deposited by chemical vapor deposition (CVD) or thermal oxidation, increases in the isolation trench density requires that large surface area be coated evenly with oxide/insulator materials to provide the desired isolation, but process limits on depositing oxide/insulator materials may result in nonuniform oxide/insulator liner thicknesses which can reduce the isolation breakdown voltage for the device. As a result, increasing component density can reduce the isolation breakdown voltage capability of the semiconductor devices. Another factor which adversely affects the isolation breakdown voltage for a particular isolation structure is temperature stresses over the operational lifetime of the component. For example, during high-temperature operating conditions, the isolation breakdown voltage of a relatively dense-structure device can be reduced due to charge injection and capture occurring in the polysilicon-oxide-silicon structure of the isolation trenches, thereby causing device failure.

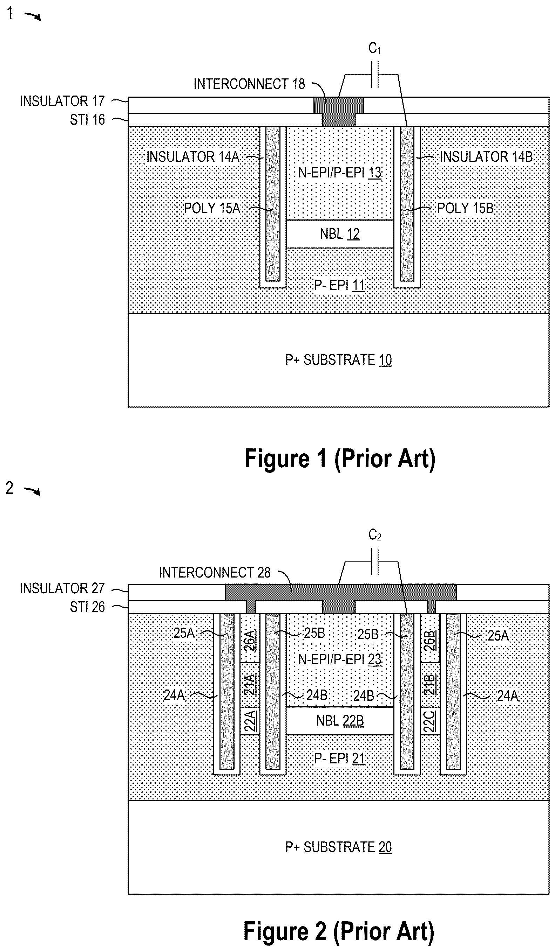

To provide additional details for an improved contextual understanding of the present disclosure, reference is now made to Figure 1 which depicts a simplified cross-sectional view of an integrated circuit device 1 employing a first prior art isolation structure wherein a conductive n-type buried layer (NBL) 12 intersects with a floating poly isolation structure formed with poly-filled deep trench ring 15A/B which extends into a p-type epitaxial layer 11 that is formed on a P+ substrate 10, thereby electrically isolating the isolated n-epi or p-epi well region 13. In the isolated n-epi or p-epi well region 13, a number of semiconductor devices, wells, or other structures may be formed. In addition, one or more metal interconnect layers are used to form a conductive interconnect 18 which makes direct electrical contact with the isolated n-epi or p-epi well region 13 through patterned insulator layer(s), such as a patterned shallow trench isolation (STI) layer 16 and/or patterned insulator layer 17. As will be appreciated, the details of the devices located in the isolated n-epi or p-epi well region 13 have been omitted from the drawings since these details are not important to the present disclosure. In general, one or more of a transistor, a resistor, a diode, a capacitor and the like, and combinations thereof, may be formed within the isolated n-epi or p-epi well region 13.

As depicted, the p-type epitaxial layer 11 includes exterior regions outside the floating poly isolation structure 15A/B and a central region positioned below the isolated n-epi or p-epi well region 13. In addition, an N-type buried layer (NBL) 12 is formed in the p-type epitaxial layer 11 over the central region of p-type epitaxial layer 11. In addition, the isolated n-epi or p-epi well region 13 is formed over the NBL 12. To electrically isolate the isolated n-epi or p-epi well region 13, the floating poly isolation structure 15A/B is formed with one or more layers of polysilicon deposited into trenches which have been lined with an oxide or insulator liner layer(s) 14A, 14B. In addition to providing structural support to the isolation structure, the floating poly isolation structure 15A/B provides protection from environmental shock, such as result from thermal expansion of isolation structure during operation of semiconductor devices formed over the n-epi/p-epi well region 13.

Before or after the formation of NBL 12 and floating poly isolation structure 15A/B in the substrate structure 10-11, a selective implantation process may be used to form the isolated n-epi or p-epi well region 13 which can be used to build components and/or circuitry. As such, there may be a number of N-type and/or P-type regions formed within the isolated n-epi or p-epi well region 13 after the desired components and/or circuitry are formed. As a result of laterally and vertically isolating the isolated n-epi or p-epi well region 13 by the floating poly isolation structure 15A/B and the NBL 12, semiconductor components formed on the isolated n-epi or p-epi well region 13 can operate without interference with or from the operation of other nearby components. In particular, lateral isolation (i.e., electrical isolation from other components formed over the substrate structure 10-11) is generally provided to the isolated n-epi or p-epi well region 13 by the floating poly isolation structure 15A/B formed about the semiconductor components. In addition, vertical isolation (i.e., electrical isolation from the substrate structure 10-11) is generally provided to the isolated n-epi or p-epi well region 13 by the NBL 12, specifically the junction between the NBL 12 and the p-type epitaxial layer 11. The junction between the NBL 12 and the p-type epitaxial layer 11 forms a PN junction that is generally reverse-biased, providing electrical isolation to isolated n-epi or p-epi well region 13 up to the isolation breakdown voltage of the component. In such a configuration, the lateral isolation provided by the floating poly isolation structure 15A/B provides more effective isolation than the vertical isolation provided by the junction between the NBL 12 and the p-type epitaxial layer 11. Accordingly, the vertical isolation provided by the PN junction between the NBL 12 and the p-type epitaxial layer 11 becomes a limiting factor for the isolation breakdown voltage of the structure. The weakest points of isolation are generally found at the hotspot region in the p-type epitaxial layer 11 between the floating poly isolation structure 15A/B and below the NBL 12. Thus, this breakdown voltage of the entire isolation structure may be referred to as the substrate breakdown voltage, or BV_{SUB}. Given a particular BV_{SUB} for the isolation structure, the structure is then given a rated isolation voltage (V_{ISO-RATED}) which, when the isolation structure is operated at V_{ISO-RATED}, provides enough margin for safe operation of the isolation structure. In an example component that may employ the structure shown in Figure 1, the breakdown voltage BV_{SUB} can be approximately about 30V higher than the rated voltage (V_{ISO-RATED}) or allowing the technology to be rated about 30V less than BV_{SUB}. Accordingly, the voltage within isolated n-epi or p-epi well region 13 can vary from 0V to V_{ISO-RATED} V during normal component operations. It should be noted that higher BV_{SUB} values result in higher rated voltage V_{ISO-RATED} values which are desired to enable new circuit applications.

In operation, the isolated n-epi or p-epi well region 13 and NBL 12 both operate at a first potential (e.g., V1) that is provided by the conductive interconnect 18, while the substrate structure 10-11 is set to a second potential (e.g., V2 or ground). With the floating poly isolation structure 15A/B having a floating potential, V_{FLOATING_POLY}, the potential of the floating poly isolation structure 15A/B is free to float and becomes coupled to a potential influenced by V1 and V2, where the coupling is analogous to coupling capacitance C₁ between the floating poly isolation structure 15A/B and the isolated n-epi or p-epi well region 13. For example, if V1 is equal to V_{ISO-RATED} for a conventional device and V2 is equal to 0V, the voltage V_{FLOATING_POLY} may float to approximately 30% of V1. Accordingly, the entire voltage V_{ISO-RATED} is dropped across the weakest part of the isolation structure at the hotspot region. For the trench-based isolation structure depicted in Figure 1, the hotspot region is limited by the poly potential value which is affected by the relatively small capacitive coupling C₁ between the floating poly isolation structure 15A/B and the isolated n-epi or p-epi well region 13. While the first prior art isolation structure depicted in Figure 1 is characterized by a high holding voltage Vh and good minority carrier suppression, it has relatively low breakdown voltage performance and breakdown voltage instability or drift.

To provide additional details for an improved contextual understanding of the present disclosure, reference is now made to Figure 2 which depicts a simplified cross-sectional view of an integrated circuit device 2 employing a second prior art isolation structure wherein a conductive n-type buried layer (NBL) 22A-C intersects with concentric poly-filled deep trench rings 24A/B which extend into a p-type epitaxial layer 21 that is formed on a P+ substrate 20, thereby electrically isolating the isolated n-epi or p-epi well region 23. In the isolated n-epi or p-epi well region 23, a number of semiconductor devices, wells, or other structures may be formed. Again, the details of the devices located in the isolated n-epi or p-epi well region 23 have been omitted from the drawings since these details are not important to the present disclosure. In addition, one or more metal interconnect layers are used to form a conductive interconnect 28 which makes direct electrical contact with the isolated n-epi or p-epi well region 23 through patterned insulator layer(s), such as a patterned STI layer 26 and/or patterned insulator layer 27.

As depicted, the substrate structure may include a P+ substrate layer 20 and a p-type epitaxial layer 21 formed on the P+ substrate layer 20, where the p-type epitaxial layer 21 includes exterior regions outside the concentric poly-filled deep trench rings 24A/B and a central region positioned below the isolated n-epi or p-epi well region 23. In addition, an N-type buried layer (NBL) 22A-C is formed in the substrate structure 20-21 over the central region of p-type epitaxial layer 21 to extend across the plurality of concentric poly-filled deep trench rings 24A/B that are formed in the substrate structure 20-21. In addition, the isolated n-epi or p-epi well region 23 is formed over a central portion of the NBL 22B which also includes peripheral NBL regions 22A, 22C which extend past the peripheral sides of the isolated n-epi or p-epi well region 23. To electrically isolate the n-epi or p-epi well region 23, a first interior polysilicon ring structure 25B is disposed in a first interior trench which has been lined with an oxide or insulator liner layer(s) 24B. In addition, a second exterior polysilicon ring structure 25A is concentrically disposed in a second exterior trench which has been lined with an oxide or insulator liner layer(s) 24A. Each additional or exterior poly-filled deep trench ring (e.g., 24A/25A) is paired with a punch-through structure which is formed with shallow implant regions 26A, 26B of the second conductivity type which are formed over regions of the p-type epitaxial layer 21A, 21B of the first conductivity type, where the resulting punch-through structure is configured to reduce the potential subjected to the weak points of the isolation structure. In addition to providing structural support to the isolation structure, the polysilicon structures 25A, 25B provide protection from environmental shock, such as result from thermal expansion of isolation structure during operation of one or more of the semiconductor devices formed over the substrate structure 20-21.

Before or after the formation of NBL 22A-C and the concentric poly-filled deep trench rings 24A/25A, 24B/25B in the substrate 20-21, one or more selective implantation processes may be used to form the isolated n-epi or p-epi well region 23 which can be used to build components and/or circuitry. In addition, the shallow implant regions 26A, 26B may also be selectively implanted to define punch-through structures created by the junctions between regions 26A/26B and the underlying regions of the p-type epitaxial layer 21A, 21B. As a result of laterally and vertically isolating the n-epi or p-epi well region 23 by, respectively, the concentric poly-filled deep trench rings 24A/25A, 24B/25B and the NBL 22B, semiconductor components formed on the isolated n-epi or p-epi well region 23 can operate without interference with or from the operation of other nearby components. In addition, the punch-through structures created by the junctions between regions 26A/26B and 21A/21B operate to distribute the potential more evenly across the whole isolation structure. As such, the electrical field formed within the isolation structure is spread out across the main isolation junction beneath isolated n-epi or p-epi well region 23 as well as the isolation junctions of the additional isolation trench rings and punch-through structures.

With the floating polysilicon structures 25A, 25B being surrounded by oxide or insulator layers 24A, 24B, each have a floating potential, V_{FLOATING_POLY} which is free to float and may become coupled to a potential falling somewhere between V1 and V3 (the coupling is analogous to capacitive coupling). In this example, because of the relatively large capacitive coupling C₂, V_{FLOATING_POLY} is about 70% of V1. This causes the hotspot to move to the bottom of the trench where V_{FLOATING_POLY} and V2 potential difference leads to high electric fields.

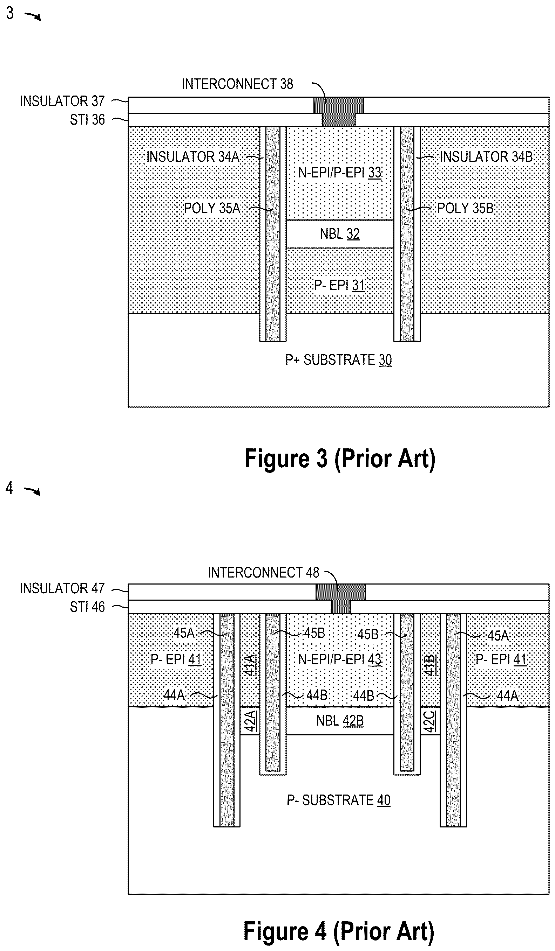

To provide additional details for an improved contextual understanding of the present disclosure, reference is now made to Figure 3 which depicts a simplified cross-sectional view of an integrated circuit device 3 employing a third prior art isolation structure wherein an n-epi or p-epi well region 33 formed in a substrate structure 30, 31 is electrically isolated by a conductive n-type buried layer (NBL) 32 that intersects with a poly-filled deep trench ring 35A/B which extends through a p-type epitaxial layer 31 and into a p+ substrate layer 30. Though the NBL layer 32 is shown as extending between the poly-filled deep trench ring 35A/B, it will be appreciated that the NBL layer 32 may extend past the poly-filled deep trench ring 35A/B and into the peripheral sides of the p-type epitaxial layer 31. As depicted, the isolated n-epi or p-epi well region 33 is formed in a substrate structure which includes a first P+ substrate layer 30 and a P-type epitaxial layer 31 formed on the P+ substrate layer 30. In addition, the poly-filled deep trench ring 35A/B is shorted to the p+ substrate layer 30 by depositing one or more layers of polysilicon 35A/B into deep trenches which have been lined on their sidewalls (but not the bottom) with one or more oxide or insulator liner layer(s) 34A, 34B so that the polysilicon layer(s) 35A/B make direct contact with the p+ substrate layer 30 at the bottom of the deep trenches. In the isolated n-epi or p-epi well region 33, a number of semiconductor devices, wells, or other structures may be formed, but the details of the devices have been omitted from the drawings since these details are not important to the present disclosure. In addition, one or more metal interconnect layers are used to form a conductive interconnect 38 which makes direct electrical contact with the isolated n-epi or p-epi well region 33 through patterned insulator layer(s), such as a patterned STI layer 36 and/or patterned insulator layer 37. While the third prior art isolation structure depicted in Figure 3 is characterized by a high holding voltage Vh, good minority carrier suppression, and a stable breakdown voltage, it has relatively low breakdown voltage performance.

To provide additional details for an improved contextual understanding of the present disclosure, reference is now made to Figure 4 which depicts a simplified cross-sectional view of an integrated circuit device 4 employing a fourth prior art isolation structure wherein an n-epi or p-epi well region 43 formed in a substrate structure 40, 41 is electrically isolated by a conductive n-type buried layer (NBL) 42A-C that intersects with concentric poly-filled deep trench rings 44A/B, 45A/B which extends through a p-type epitaxial layer 41 and into a p- substrate layer 40. Though the NBL layer 42A-C is shown as extending between the concentric poly-filled deep trench rings 44A/B, 45A/B, it will be appreciated that the NBL layer 42A-C may extend past the concentric poly-filled deep trench rings 44A/B, 45A/B and into the peripheral sides of the p- substrate layer 40. As depicted, the isolated n-epi or p-epi well region 43 is formed in a substrate structure which includes a first p-substrate layer 40 and a P-type epitaxial layer 41 formed on the p- substrate layer 40. In the substrate structure 40, 41, the concentric poly-filled deep trench rings 44A/B, 45A/B are formed to include a first interior polysilicon ring structure 45B that is disposed in a first interior trench that extends into the p- substrate 40 and which has been lined with an oxide or insulator liner layer(s) 44B. In addition, the concentric poly-filled deep trench rings 44A/B, 45A/B are formed to include a second exterior polysilicon ring structure 45A that is concentrically disposed in a second exterior trench that extends more deeply into the p-substrate 40 and which has been lined with an oxide or insulator liner layer(s) 44A. Thus, the second exterior polysilicon ring structure 45A is deeper than the first interior polysilicon ring structure 45B. In addition, the second exterior polysilicon ring structure 45A is shorted to the p- substrate layer 40 by depositing one or more layers of polysilicon 45A into deep trenches which have been lined on their sidewalls (but not the bottom) with one or more oxide or insulator liner layer(s) 44A so that the polysilicon layer(s) 45A make direct contact with the p- substrate layer 40 at the bottom of the deep trenches. In the isolated n-epi or p-epi well region 43, a number of semiconductor devices, wells, or other structures may be formed, but the details of the devices have been omitted from the drawings since these details are not important to the present disclosure. In addition, one or more metal interconnect layers are used to form a conductive interconnect 48 which makes direct electrical contact with the isolated n-epi or p-epi well region 43 through patterned insulator layer(s), such as a patterned STI layer 46 and/or patterned insulator layer 47. While the fourth prior art isolation structure depicted in Figure 4 is characterized by a high breakdown voltage, it requires a relatively complicated fabrication process and suffers from breakdown voltage instability or drift.

As described hereinabove, there are significant challenges with conventional deep trench isolation structures implemented in bulk silicon for high voltage BCD applications, including but not limited to meeting requirements for high voltage isolation, high holding voltages, isolation breakdown voltage stability, substrate minority carrier injections, DTI process complexity, and thick sidewall oxide requirements. To overcome these such challenges and others known to those skilled in the art, there is disclosed herein a method and apparatus for meeting voltage and isolation requirements for a high voltage bulk technology in BCD applications by fabricating integrated semiconductor devices with high voltage tubs or regions surrounded and protected by multiple concentric deep trench isolation rings, at least one of which is shorted to an underlying P+ substrate layer by extending down past a conductive buried layer and through an N-epi layer to the P+ substrate layer.

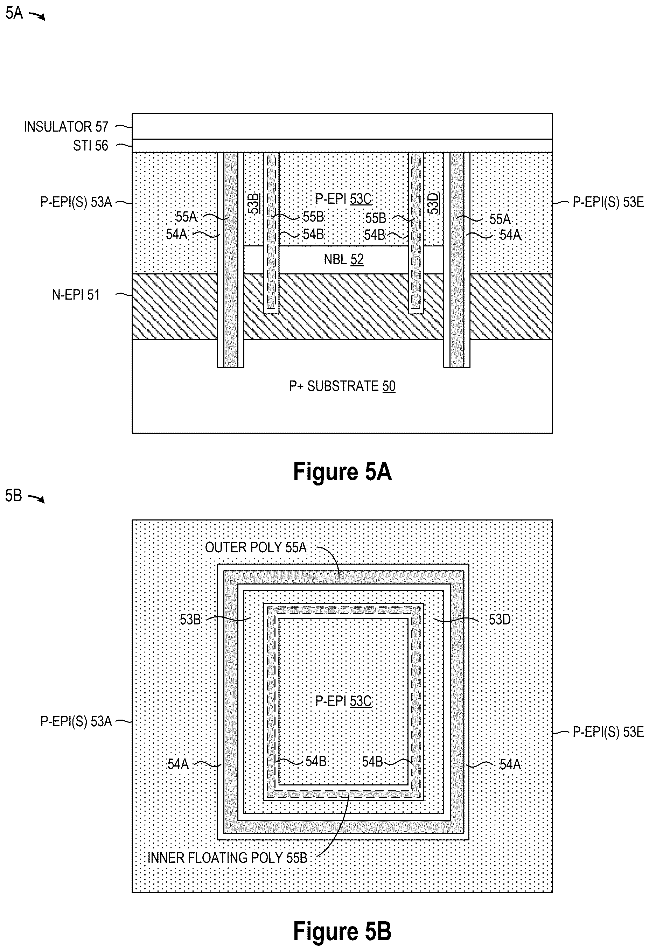

To provide a first example embodiment for isolating high voltage tubs or regions in accordance with selected embodiments of the present disclosure, reference is now made to Figure 5A which depicts a simplified cross-sectional view 5A of a high voltage BCD integrated circuit wherein a p-epi well region 53C is electrically isolated by a double deep trench isolation (DTI) structure 55A/B formed with two concentric deep trench rings, including a relatively deep outer DTI structure 55A extending down through an N-epi layer 51 to a P+ substrate layer 50 and relatively shallow inner DTI structure 55B extending down to (but not through) an N-epi layer 51. In addition, Figure 5B shows a top plan view 5B of the integrated circuit shown in Figure 5A. As depicted, the high voltage BCD integrated circuit is formed in a substrate structure 50-53 which includes a first P+ substrate layer 50, one or more n-type epitaxial layers 51 located on the first P+ substrate layer 50, a conductive n-type buried layer (NBL) 52 located on the n-type epitaxial layer(s) 51, and one or more p-type epitaxial layers 53A-E located over the conductive NBL layer 52 and n-type epitaxial layer(s) 51. The depicted conductive NBL layer 52 may be formed in the substrate structure 50-53 by implanting n-type impurities into the one or more p-type epitaxial layers 53. For example, any suitable implant process may be used to selectively implant n-type impurities into the p-type epitaxial layer(s) 53A-E to a predetermined depth and concentration that is located above the n-type epitaxial layer(s) 51 and that positioned below the intended p-epi well region 53C. As depicted, the conductive NBL layer 52 may extend between the concentric DTI structures 54A/B, 55A/B, but it will be appreciated that the conductive NBL layer 52 may extend past the concentric DTI structures and into the peripheral sides of the p-type epitaxial layer(s) 53A, 53E. After formation of the conductive NBL layer 52, one or more additional p-type epitaxial layer(s) 53A-E may be deposited.

After forming the p-type epitaxial layer(s) 53A-E, the double deep trench isolation (DTI) structure 55A/B may be formed to surround the p-epi well region 53C to extend past the conductive NBL layer 52. In particular, a relatively deep outer DTI structure 55A is formed to be shorted to the first P+ substrate layer 50 by selectively etching a deep trench ring opening into the substrate structure 50-53 that surrounds the p-epi well region 53C and exposes the first P+ substrate layer 50, conformally depositing in insulating oxide layer 54A on the bottom and sidewall surfaces of the deep trench ring opening, selectively removing the insulating oxide layer 54A from the bottom surfaces of the deep trench ring opening, and then filling the deep trench ring opening with one or more deposited polysilicon layers 55A to make direct contact with the first P+ substrate layer 50. In addition, a relatively shallow inner DTI structure 55B is formed to extend into (but not past) the n-type epitaxial layer(s) 51 by selectively etching a concentric shallow trench ring opening into the substrate structure 50-53 that surrounds the p-epi well region 53C and is positioned inside the deep trench ring opening, conformally depositing in insulating oxide layer 54B on the bottom and sidewall surfaces of the concentric shallow trench ring opening, and then filling the concentric shallow trench ring opening with one or more deposited polysilicon layers 55B. In selected embodiments, the concentric shallow trench ring opening may be completely filled with the insulating oxide layer 54B so that there are no deposited polysilicon layers 55B (as indicated with the dashed lines). Though a single concentric shallow inner DTI structure 55B is shown, it will be appreciated that one or more additional concentric shallow inner DTI structures may be formed to protect, surround, and isolate the p-epi well region 53C. In addition, the relatively deep outer DTI structure 55A may be formed with the same fabrication processing steps as used to form the concentric shallow inner DTI structure(s) 55B, or separate fabrication processing steps may be used. For example, DTI structures of different depths can be formed by defining a deep trench etch mask with larger openings where the relatively deep outer DTI structure 55A will be formed, and with smaller openings where the concentric shallow inner DTI structure 55B will be formed. In the isolated p-epi well region 53C, a number of semiconductor devices, wells, or other structures (e.g., BJT, MOSFETs, diodes, CMOS, DMOS, etc.) may be formed, though details of the devices are not shown since these details are not important to the present disclosure.

With the high voltage BCD integrated circuit depicted in Figures 5A-B, two or more concentric DTI structures 55A, 55B are disposed to surround and protect the high voltage tubs or regions 53C, including a deep outer DTI structure 55A that extends through the n-type epitaxial layer(s) 51 to contact the first P+ substrate layer 50, and a concentric shallow inner DTI structure 55B that extends only to the n-type epitaxial layer(s) 51. The deep outer DTI structure 55A is formed with polysilicon in a deep trench ring opening that is lined on the sidewalls with insulating liner layer 54A so that the polysilicon is connected and shorted to the first P+ substrate layer 50. In addition, the concentric shallow inner DTI structure 55B is a floating structure that may be formed in a shallow trench ring opening that is filled entirely with an insulating layer 54B, or that may optionally include a floating polysilicon layer.

In the depicted first example embodiment for isolating high voltage tubs or regions in the high voltage BCD integrated circuit, the double deep trench isolation (DTI) structure 55A/B provides lateral electrical isolation for the isolated p-epi well region 53C. In addition, vertical electrical isolation is provided by the conductive NBL 52. Though not shown, it will be appreciated that one or more metal interconnect layers may formed in the STI layer 56 and insulator layer 57 to make direct, electrical contact with the isolated p-epi well region 53C. As a result, the depicted first example embodiment for isolating high voltage configuration is characterized by a high holding voltage Vh, high breakdown voltage, stable breakdown voltage, good minority carrier suppression.

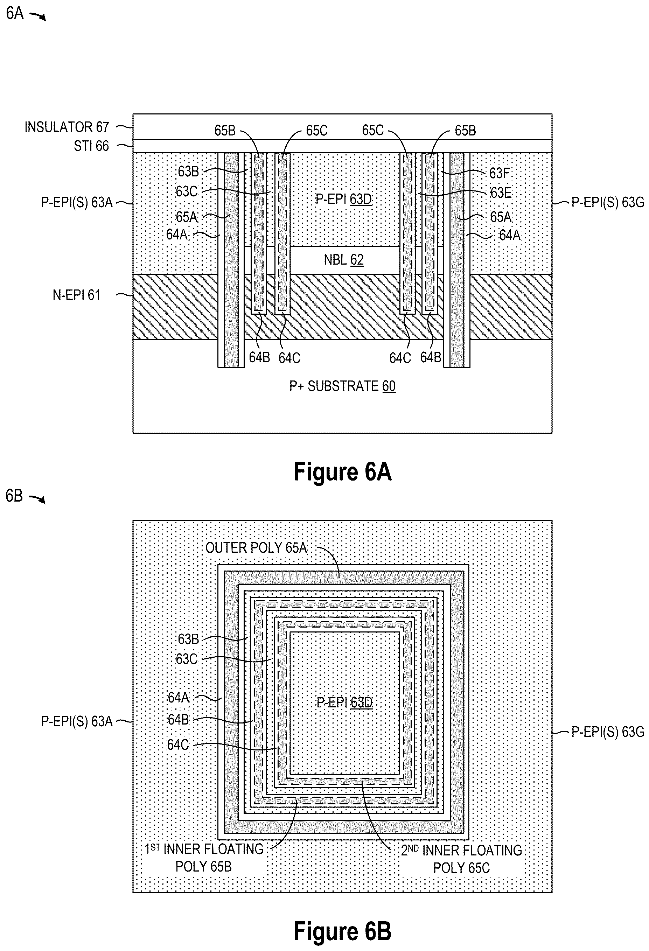

To provide a second example embodiment for isolating high voltage tubs or regions in accordance with selected embodiments of the present disclosure, reference is now made to Figure 6A which depicts a simplified cross-sectional view 6A of a high voltage BCD integrated circuit wherein a p-epi well region 63D is electrically isolated by a triple deep trench isolation (DTI) structure 65A-C formed with three concentric deep trench rings, including a relatively deep outer DTI structure 65A extending down through an N-epi layer 61 to a P+ substrate layer 60 and two relatively shallow inner DTI structure 65B, 65C extending down to (but not through) an N-epi layer 61. In addition, Figure 6B shows a top plan view 6B of the integrated circuit shown in Figure 6A. As depicted, the high voltage BCD integrated circuit is formed in a substrate structure 60-63 which includes a first P+ substrate layer 60, one or more n-type epitaxial layers 61 located on the first P+ substrate layer 60, a conductive n-type buried layer (NBL) 62 located on the n-type epitaxial layer(s) 61, and one or more p-type epitaxial layers 63A-G located over the conductive NBL layer 62 and n-type epitaxial layer(s) 61. The depicted conductive NBL layer 62 may be formed in the substrate structure 60-63 by implanting n-type impurities into the one or more p-type epitaxial layers 63. While the conductive NBL layer 62 may extend between the concentric DTI structures 65A-C as shown, it will be appreciated that the conductive NBL layer 62 may extend past the concentric DTI structures 65A-C and into the peripheral sides of the p-type epitaxial layer(s) 63A, 63G. After formation of the conductive NBL layer 62, one or more additional p-type epitaxial layer(s) 63A-G may be deposited.

After forming the p-type epitaxial layer(s) 63A-G, the triple deep trench isolation (DTI) structure 65A-C may be formed to surround the p-epi well region 63D to extend past the conductive NBL layer 62. In particular, a relatively deep outer DTI structure 65A is formed to be shorted to the first P+ substrate layer 60 by selectively etching a deep trench ring opening into the substrate structure 60-63 that surrounds the p-epi well region 63D and exposes the first P+ substrate layer 60, conformally depositing in insulating oxide layer 64A on the bottom and sidewall surfaces of the deep trench ring opening, selectively removing the insulating oxide layer 64A from the bottom surfaces of the deep trench ring opening, and then filling the deep trench ring opening with one or more deposited polysilicon layers 65A to make direct contact with the first P+ substrate layer 60. In addition, two or more relatively shallow inner DTI structures 65B, 65C are formed to extend into (but not past) the n-type epitaxial layer(s) 61 by selectively etching a concentric shallow trench ring openings into the substrate structure 60-63 that surround the p-epi well region 63D and that are positioned inside the deep trench ring opening, conformally depositing in insulating oxide layer 64B, 64C on the bottom and sidewall surfaces of the concentric shallow trench ring openings, and then filling the concentric shallow trench ring openings with one or more deposited polysilicon layers 65B, 65C. In selected embodiments, the concentric shallow trench ring openings may be completely filled with the insulating oxide layer 64B, 64C so that there are no deposited polysilicon layers 65B, 65C (as indicated with the dashed lines). In addition, the relatively deep outer DTI structure 65A may be formed with the same fabrication processing steps as used to form the concentric shallow inner DTI structures 65B, 65C, or separate fabrication processing steps may be used. In the isolated p-epi well region 63D, a number of semiconductor devices, wells, or other structures (e.g., BJT, MOSFETs, diodes, CMOS, DMOS, etc.) may be formed, though details of the devices are not shown since these details are not important to the present disclosure.

In selected embodiments, shallow n-type implant regions may be selectively formed as a second n-well ring region in the p-type epitaxial layers 63C, 63E between the concentric shallow inner DTI structures 64B, 64C to form a punch-through structure which is configured to reduce the potential subjected to the weak points of the isolation structure.

With the high voltage BCD integrated circuit depicted in Figures 6A-B, three concentric DTI structures 65A-C are disposed to surround and protect the high voltage tubs or regions 63D, including a deep outer DTI structure 65A that extends through the n-type epitaxial layer(s) 61 to contact the first P+ substrate layer 60, a first concentric shallow inner DTI structure 65B that extends only to the n-type epitaxial layer(s) 61, and a second concentric shallow inner DTI structure 65C that extends only to the n-type epitaxial layer(s) 61. The deep outer DTI structure 65A is formed with polysilicon in a deep trench ring opening that is lined on the sidewalls with insulating liner layer 64A so that the polysilicon is connected and shorted to the first P+ substrate layer 60. In addition, the concentric shallow inner DTI structures 65B, 65C are floating structures that may be formed in a shallow trench ring opening that is filled entirely with an insulating layer 64B, 64C, or that may optionally include a floating polysilicon layer.

In the depicted second example embodiment for isolating high voltage tubs or regions in the high voltage BCD integrated circuit, the triple deep trench isolation (DTI) structure 65A-C provides lateral electrical isolation for the isolated p-epi well region 63D. In addition, vertical electrical isolation is provided by the conductive NBL 62. Though not shown, it will be appreciated that one or more metal interconnect layers may formed in the STI layer 66 and insulator layer 67 to make direct, electrical contact with the isolated p-epi well region 63D. As a result, the depicted second embodiment for isolating high voltage configuration is characterized by a high holding voltage Vh, high breakdown voltage, stable breakdown voltage, good minority carrier suppression.

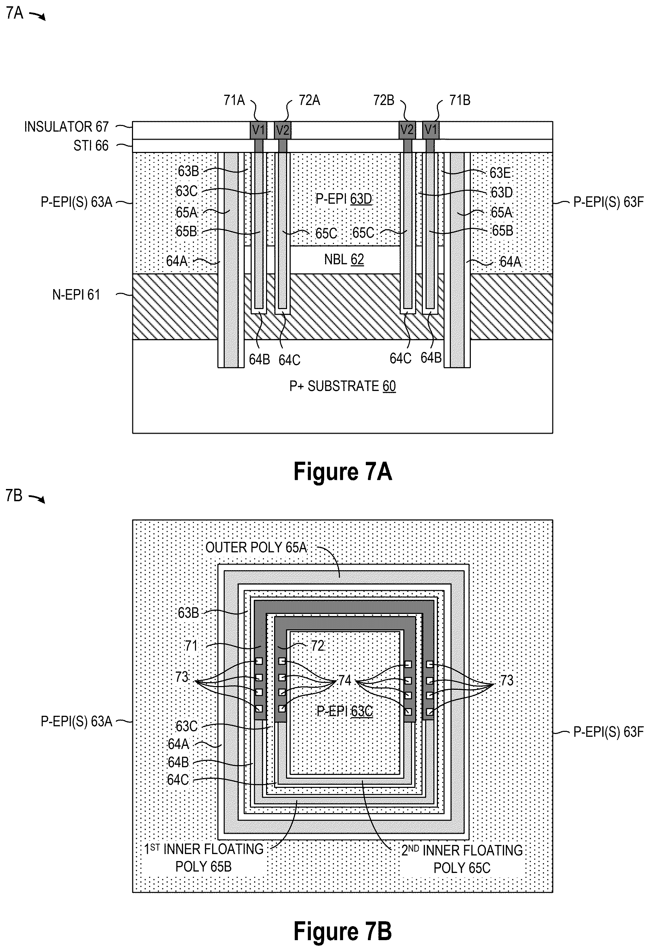

To provide a third example embodiment for isolating high voltage tubs or regions in accordance with selected embodiments of the present disclosure, reference is now made to Figure 7A which depicts a simplified cross-sectional view 7A of a high voltage BCD integrated circuit that is identical to the HV BCD IC shown in Figure 6A except that the relatively shallow inner DTI structure 65B, 65C are directly, electrically connected to separate predetermined voltages V1, V2 over one or more metal interconnect layers 71A/71B, 72A/B formed in the STI layer 66 and insulator layer 67. Thus, the third example embodiment of the HV BCD IC depicted in Figures 7A-B includes a substrate structure 60-63 in which the p-epi well region 63D is electrically isolated by the triple DTI structure 65A-C and the conductive NBL layer 62 which are disposed to surround and protect the high voltage tubs or regions 63D, including a deep outer DTI structure 65A that extends through the n-type epitaxial layer(s) 61 to contact the first P+ substrate layer 60, a first concentric shallow inner DTI structure 65B that extends only to the n-type epitaxial layer(s) 61, a second concentric shallow inner DTI structure 65C that extends only to the n-type epitaxial layer(s) 61, and a conductive NBL layer 62 that is implanted or otherwise formed in the p-type epitaxial layers 63B-F to extend between the concentric DTI structures 65A-C as shown. After forming the triple DTI structure 65A-C in the substrate structure 60-63, one or more metal interconnect layers 71A/71B are formed in the patterned STI layer 66 and/or patterned insulator layer 67 to form a conductive contact 71 to make direct electrical contact with the concentric shallow inner DTI structures 65B for electrical connection to a first predetermined voltage V1 through underlying conductive vias 73. At the same time, one or more metal interconnect layers 72A/72B are formed in the patterned STI layer 66 and/or patterned insulator layer 67 to form a conductive contact 72 to make direct electrical contact with the concentric shallow inner DTI structure 65C for electrical connection to a second predetermined voltage V2 through underlying conductive vias 74. As a result, the depicted third embodiment for isolating high voltage configuration is characterized by a high holding voltage Vh, high breakdown voltage, stable breakdown voltage, good minority carrier suppression. While the high voltage BCD integrated circuit shown in Figures 7A-B includes a triple DTI structure 65A-C with the concentric shallow inner DTI structures 65B, 65C connected to separate voltages, it will be appreciated that the high voltage BCD integrated circuit may include a double DTI structure 65A-B with a single shallow inner DTI structure (e.g., 65B) that is connected to a predetermined voltage.

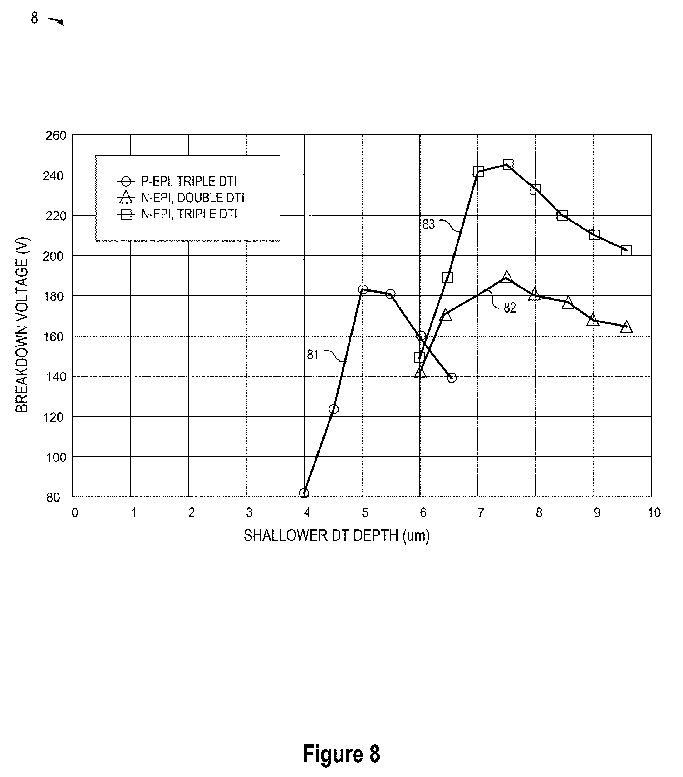

For an improved understanding of selected embodiments of the present disclosure, reference is now made to Figure 8 which depicts a simulated plot 8 of breakdown voltages as a function of the shallower DTI structure depth for purposes of evaluating different isolation structures. In this simulation, the y-axis provides the breakdown voltage values for the NBL to the substrate region and the x-axis shows the depth of the shallower deep trench isolation structure. As can be seen from the depicted plots 81-83, the triple DTI structure which extends through an n-type epitaxial layer has the highest breakdown voltage compared to double DTI with N-epi or triple DTI with P-epi.

In particular, the depicted plot 81 shows the breakdown voltage plot for a triple DTI structure having a deep DTI structure which extends through a p-type epitaxial layer formed on a p+ substrate layer. In the depicted plot 81, the breakdown voltage (BV) has a relatively low value (e.g., BV=80V) for a shallow DTI structure having a depth of 4 um. As the depth of the shallow DTI structure increases to 5um, the breakdown voltage value increases to reach a peak value (e.g., BV=184V), and then the breakdown voltage value decreases (e.g., BV=138V) as the depth of the shallow DTI structure increases to 6um.

In addition, the depicted plot 82 shows the breakdown voltage plot for a double DTI structure having a deep DTI structure which extends through an n-type epitaxial layer formed on a p+ substrate layer, similar to the example embodiment shown in Figure 5A. In the depicted plot 82, the breakdown voltage (BV) has a relatively low value (e.g., BV=142V) for a shallow DTI structure having a depth of 6 um. As the depth of the shallow DTI structure increases to 7.55um, the breakdown voltage value increases to reach a peak value (e.g., BV=190V), and then the breakdown voltage value decreases (e.g., BV=165) as the depth of the shallow DTI structure increases to 9.5um.

In addition, the depicted plot 83 shows the breakdown voltage plot for a triple DTI structure having a deep DTI structure which extends through an n-type epitaxial layer formed on a p+ substrate layer, similar to the example embodiment shown in Figure 6A. In the depicted plot 83, the breakdown voltage (BV) has a relatively low value (e.g., BV=147V) for a shallow DTI structure having a depth of 6 um. As the depth of the shallow DTI structure increases to 7.55 um, the breakdown voltage value increases to reach a peak value (e.g., BV=245V), and then the breakdown voltage value decreases (e.g., BV=205) as the depth of the shallow DTI structure increases to 9.5 um.

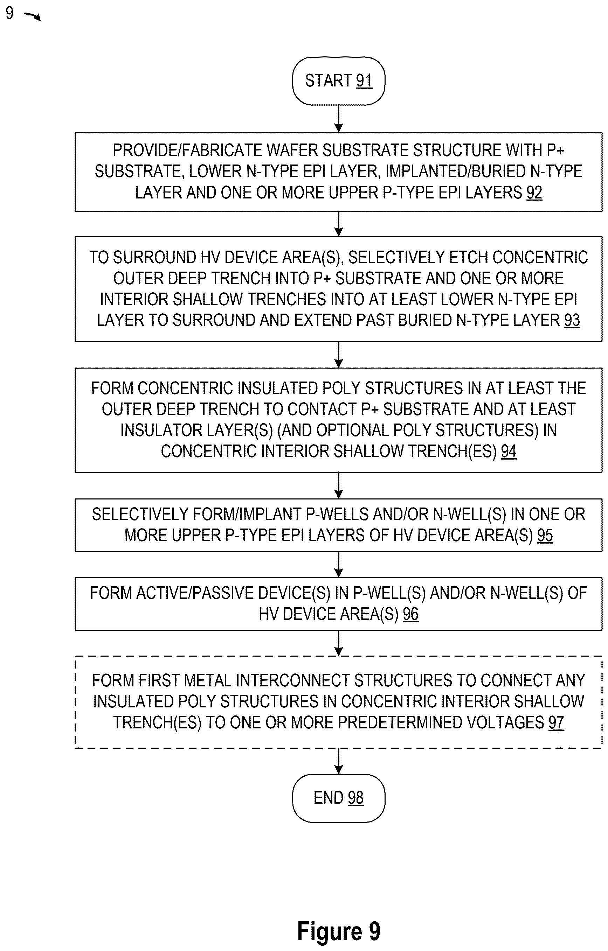

To provide additional details for an improved understanding of selected embodiments of the present disclosure, reference is now made to Figure 9 which depicts a simplified flow chart showing the process flow 9 for fabricating a high voltage tub having concentric deep and shallow DTI structures to protect an inner N-well region of high voltage device area. In describing the fabrication process flow 9, various reference numbers, doping types and concentrations are provided by way of examples of different regions that can be formed, but this is intended merely to facilitate understanding of various exemplary embodiments and not by way of limitation. After the process starts at step 91, a sequence of fabrication steps 92-98 are performed to fabricate a wafer containing multiple dice, where each die includes a single substrate having one or more high voltage tub isolation structures in which is formed a number of independent semiconductor components, such as bipolar devices, CMOS devices, and/or DMOS devices. As will be appreciated, the specific sequence of steps may be modified or changed. In addition, certain steps may be implemented with a plurality of separate processing steps, may be omitted and/or performed separately.

In step 92, a substrate structure is provided or fabricated with a lower n-type epitaxial layer, buried n-type layer, and one or more upper p-type epitaxial layers formed over a semiconductor substrate layer. With respect to the fabrication step 52, a number of steps may be used, starting with preparing a P+ semiconductor substrate layer having a first conductivity type (e.g., p-type) and P+ doping concentration (e.g., ranging between 5e17-5e19 cm⁻³) for subsequent processing. On the P+ semiconductor substrate layer, a first n-type epitaxial semiconductor layer of the second conductivity type (e.g., N-epi 61) is formed, such as by epitaxially growing and planarizing a first, lightly doped n-type layer over the P+ substrate structure layer to a predetermined thickness (e.g., approximately 5-25 um) and doping concentration (e.g., approximately 1e14-1e16 cm⁻³). On the first n-type epitaxial semiconductor layer, a patterned buried layer (e.g., NBL 62) may be formed to be located in the area(s) of the intended high voltage tub region(s). In forming the patterned buried layer, selective masking and implantation or diffusion techniques may be used, or alternatively selective epitaxial growth may be used with controlled doping conditions to form the patterned buried layer. For example, the patterned buried layer may be formed by first depositing a first p-type epitaxial layer on the formed the first n-type epitaxial semiconductor layer, and then selectively implanting the first p-type epitaxial layer with an n-type impurity having a predetermined doping concentration (e.g., 1e17-1e20 cm⁻³) and energy to form the patterned buried layer having a predetermined thickness in the first p-type epitaxial layer. Subsequently, one or more additional p-type epitaxial semiconductor layers (e.g., p-epi 63) are formed over the first n-type epitaxial semiconductor layer to cover the patterned buried layer, such as by epitaxially growing and planarizing a second, lightly doped p-type layer to a predetermined thickness (e.g., approximately 5-15 um) and doping concentration (e.g., approximately 1e14 - 1e16 cm⁻³). Alternatively, a single p-type epitaxial semiconductor layer may be formed over the first n-type epitaxial semiconductor layer, followed by implantation of n-type impurities and subsequent annealing to form the n-type patterned buried layer.

In step 93, the substrate structure is selectively etched to form concentric interior trench and outer trench openings to surround the high voltage (HV) device areas, including an outer deep trench opening that extends down to the P+ semiconductor substrate layer and one or more interior shallow trench openings that are concentrically positioned with the outer deep trench opening and that extend past the patterned buried layer and into (but not past) the first n-type epitaxial semiconductor layer. With respect to the fabrication step 93, a number of steps may be used, such as by forming patterned masks, such as a photoresist mask (not shown), on the substrate structure to define etching openings where the concentric interior and outer trench openings will be formed and positioned in relation to the subsequently-formed isolated well regions. As disclosed, the patterned mask may include smaller mask openings located over the intended interior shallow trench opening(s), and larger mask openings located over the intended outer deep trench opening. Subsequently, a selective etch process can include using the patterned mask to perform one or more deep reactive-ion etching (RIE) steps having suitable etch chemistry properties to remove exposed portions of the semiconductor substrate to form the outer deep trench opening and the one or more interior shallow trench openings. By controlling the relative size of the etching openings in the patterned mask, a single deep RIE etch may be applied to simultaneously etch the outer deep trench opening (through the one or more upper p-type epitaxial layers, the patterned buried layer, the lower n-type epitaxial layer, and into the P+ semiconductor substrate layer) and the one or more interior shallow trench openings (through the one or more upper p-type epitaxial layers and the patterned buried layer and into (but not past) the lower n-type epitaxial layer). In selected embodiments, the etch process may be controlled to form outer deep trench openings that extend up to 6-30 um below the bottom junction depth of the patterned buried n-type layer and to form one or more shallow inner deep trench openings that extend into, but not past, the patterned buried n-type layer.

In step 94, concentric insulated poly structures are formed in at least the outer deep trench opening to contact the P+ semiconductor substrate layer to define a portion of an isolation structure surrounding the isolated region. In addition, at least one or more insulator layers are formed in the one or more interior shallow trench openings, alone or in combination with poly structures to define a portion of the isolation structure surrounding the isolated region. With respect to fabrication step 94, a number of steps may be used to form the floating poly structures, such as by depositing a conformal insulation layer on the sidewalls of the outer deep trench openings and one or more interior shallow trench openings. In selected embodiments, the conformal insulation layer may be formed with oxide, nitride, or a combination of both to a controlled thickness. Subsequently, a directional etch process may be selectively applied, such as by applying an etch mask and anisotropic etch process to selectively remove the conformal insulation layer from only the bottom of the outer deep trench openings to expose the underlying P+ semiconductor substrate layer. Subsequently, the remaining portions of the outer deep trench openings and one or more interior shallow trench openings are filled with a conductive filling material, such as by depositing a highly doped polysilicon plug to fill the trench openings. In selected embodiments, the one or more interior shallow trench openings are not filled with conductive filling material, but are filled only with the conformal insulation layer. If needed, one or more processing steps may be applied to planarize the concentric poly structures with the remainder of the substrate, such as by applying a polish step to the surface of the substrate structure. As will be appreciated, the concentric floating poly structures may be formed and positioned to surround and protect a first isolated n-well or p-well region wherein the BCD devices will subsequently be formed. In addition, one or more shallow trench isolation structures may be formed over the substrate as concentric poly structures by patterning and etching shallow trench openings in the upper surface of the substrate, filling the openings with one or more insulating dielectric layers and poly layers, and then polishing or planarizing the filling layers down to the surface of the substrate to form the shallow trench isolation (STI) structures.

In step 95, one or more p-wells and/or n-wells are formed in the upper p-type epitaxial layer to be surrounded by the concentric floating poly structures and the buried n-type layer, either before or after forming the concentric floating poly structures. With respect to the fabrication step 95, a number of steps may be used to form the one or more p-wells and/or n-wells in the upper p-type epitaxial layer, such as by using any suitable pattern, mask, and implantation steps. For example, a first implant mask may be formed over the substrate structure with one or more defined openings which expose the regions of the upper p-type epitaxial layer that is surrounded by concentric floating poly structures. Subsequently, a selective implantation process may be applied to form the high voltage p-well and/or n-well regions in the upper p-type epitaxial layer so as to be completely contained and surrounded by the concentric floating poly structures. For example, the selective implantation process may implant n-type impurities at a predetermined density and energy to define the HV n-well to a depth that extends down to the n-type buried layer.

In step 96, one or more active devices are formed in the one or more p-well and/or n-well regions of the HV device area(s). With respect to the fabrication step 96, a number of steps may be used to form the active device(s), such as additional well regions, gate electrodes, and associated source/drain regions, on the surface of the p-well and/or n-well regions. For example, well regions may be formed by doping the upper p-type epitaxial layer with any suitable dopant implantation procedure to define a n-type or p-type well regions. In addition, gate electrodes may be selectively formed by depositing, patterning, and etching a conductive polysilicon layer formed over one or more gate dielectric layers, and then used with one or more selective masks to implant the source and/or drain regions. As will be appreciated, other device regions, such as shallow trench insulators or resistors, may also be formed at this time.

In step 97, one or more metal interconnect structures may optionally be formed (as indicated by the dashed lines) to connect or short any poly structures in the concentric interior shallow trench(es) to one or more predetermined voltages. With respect to the fabrication step 97, a number of steps may be used to form the metal interconnect structure(s), such as by using a damascene process to form or more patterned conductive interconnect layers 71, 72 to extend through patterned openings in the insulator layer(s) 66, 67 to make direct, shorting electrical contact with floating poly structures 65B, 65C in the concentric interior shallow trench(es). The processing at step 97 may also form interconnect paths with active devices formed in the one or more p-well and/or n-well regions of the HV device area(s).

At step 98, the fabrication methodology 9 ends. At this point, the fabrication of the semiconductor device may continue with singulation into individual integrated circuit die and additional packaging steps. Of course, the order of the acts described above may vary to form specific device regions and features needed for any particular integrated circuit application. It will be appreciated that additional processing steps will be used to fabricate the semiconductor device described herein, such as a nitride strip process, preparation and formation of one or more sacrificial oxide layers, shallow trench isolation regions, and formation of various buried well or regions. In addition, other circuit features may be formed on the wafer structure, such as capacitors, diodes, etc. As examples, one or more sacrificial oxide formation, stripping, isolation region formation, well region formation, gate dielectric and electrode formation, extension implant, halo implant, spacer formation, source/drain implant, heat drive or anneal steps, and polishing steps may be performed, along with conventional backend processing (not depicted), typically including formation of multiple levels of interconnect that are used to connect the transistors in a desired manner to achieve the desired functionality. Thus, the specific sequence of steps used to complete the fabrication of the semiconductor structures may vary, depending on the process and/or design requirements.

By now, it should be appreciated that there has been provided an integrated circuit having a high voltage tub and associated method of fabrication. As disclosed, the integrated circuit includes a substrate of a first conductivity type and a first epitaxial layer of a second conductivity type located on the substrate. In selected embodiments, the first conductivity type is p-type and the second conductivity type is n-type. In addition, the integrated circuit includes one or more additional epitaxial layers of the first conductivity type located on the first epitaxial layer. The integrated circuit also includes a buried layer of the second conductivity type located in the one or more additional epitaxial layers to be adjacent to the first epitaxial layer. In selected embodiments, the buried layer extends only below the central isolated region and does not extend laterally past the concentric deep poly isolation structure. As disclosed herein, the term "laterally" generally refers to being located at a side position or in a direction away from a midline in a plane that is parallel with a major generally planar surface of the substrate. In addition, the integrated circuit includes a central isolated region located in the one or more additional epitaxial layers to be positioned over the buried layer. The integrated circuit also includes one or more concentric shallow isolation ring structures positioned to surround the central isolated region and to extend down through the buried layer and into the first epitaxial layer. In selected embodiments, the one or more concentric shallow isolation ring structures each include one or more polysilicon layers surrounded by an insulating liner layer. In other selected embodiments, the one or more concentric shallow isolation ring structures each include only one or more insulating layers. In selected embodiments, each of the one or more concentric shallow isolation ring structures is electrically connected to a separate predetermined voltage. In addition, the integrated circuit includes a concentric deep poly isolation structure positioned to surround the central isolated region and the one or more concentric shallow isolation ring structures and to extend down through the first epitaxial layer and into the substrate, wherein the concentric deep poly isolation structure includes one or more polysilicon layers that are shorted to the substrate. In selected embodiments, the concentric deep poly isolation structure includes one or more polysilicon layers surrounded by an insulating liner layer except for a bottom portion which directly contacts the substrate.

In another form, there is provided an integrated circuit device with a high voltage tub and associated method of fabrication. As disclosed, the integrated circuit device includes a P+ substrate, an n-type epitaxial layer located on the P+ substrate, one or more p-type epitaxial layers located on the n-type epitaxial layer, and an n-type buried layer located in the one or more p-type epitaxial layers and adjacent to the n-type epitaxial layer. In addition, the integrated circuit device includes an isolated high voltage well region located in the one or more p-type epitaxial layers and over the n-type buried layer. The integrated circuit device also includes a first poly isolation ring structure concentrically disposed to surround the isolated high voltage well region and to extend through the one or more p-type epitaxial layers, the n-type buried layer, the n-type epitaxial layer, and into the P+ substrate. As formed, the first poly isolation ring structure includes one or more polysilicon layers that are shorted to the P+ substrate. In selected embodiments, the first poly isolation ring structure includes one or more polysilicon layers surrounded by an insulating liner layer except for a bottom portion which directly contacts the P+ substrate. In addition, the integrated circuit device includes a first concentric shallow isolation ring structure positioned concentrically within the first poly isolation ring structure to surround the isolated high voltage well region and to extend through the one or more p-type epitaxial layers and the n-type buried layer and into the n-type epitaxial layer. In selected embodiments, the first concentric shallow isolation ring structure includes one or more polysilicon layers surrounded by an insulating liner layer. In selected embodiments, a first voltage is connected to the one or more polysilicon layers of the first concentric shallow isolation ring structure. In selected embodiments, the integrated circuit device also includes a second concentric shallow isolation ring structure positioned concentrically within the first concentric shallow isolation ring structure to surround the isolated high voltage well region and to extend through the one or more p-type epitaxial layers and the n-type buried layer and into the n-type epitaxial layer. In such embodiments, each of the first and second concentric shallow isolation ring structures may include one or more polysilicon layers surrounded by an insulating liner layer. In addition, a first voltage may be connected to the one or more polysilicon layers of the first concentric shallow isolation ring structure, and a second voltage may be connected to the one or more polysilicon layers of the second concentric shallow isolation ring structure. In other such embodiments, each of the first and second concentric shallow isolation ring structures may include one or more insulating layers. In selected embodiments, a bipolar transistor device, a CMOS transistor device, and a DMOS transistor device are located at least partially within the isolated high voltage well region.

In yet another form, there is provided an integrated circuit device with a high voltage tub and associated method of fabrication. As disclosed, the method includes forming a substrate structure which includes a P+ substrate, an n-type epitaxial layer located on the P+ substrate, and one or more p-type epitaxial layers located on the n-type epitaxial layer, and an implanted n-type buried layer in the one or more p-type epitaxial layers to be located adjacent to the n-type epitaxial layer. In addition, the disclosed method includes selectively etching a first deep isolation trench opening and a first concentric shallow isolation trench opening in the substrate structure that are concentrically disposed to surround an isolated high voltage well region located in an upper region of the substrate structure. As formed, the first deep isolation trench opening extends into the substrate structure down through the one or more p-type epitaxial layers, the n-type buried layer, the n-type epitaxial layer, and into the P+ substrate. In addition, the first concentric shallow isolation trench opening extends into the substrate structure down through the one or more p-type epitaxial layers and the n-type buried layer and into the n-type epitaxial layer. The disclosed method also includes forming a first poly isolation ring structure in the first deep isolation trench opening. In addition, the disclosed method includes forming a first concentric shallow isolation ring structure in the first concentric shallow isolation trench opening. The disclosed method also includes selectively implanting one or more p-type or n-type wells in the isolated high voltage well region. In selected embodiments, the disclosed method also includes forming a first conductive interconnect structure for electrically connecting the first concentric shallow isolation ring structure to a predetermined voltage. In selected embodiments, a single patterned etch mask is used to simultaneously selectively etch the first deep isolation trench opening and the first concentric shallow isolation trench opening, where the single patterned etch mask includes a first mask opening formed over the first deep isolation trench opening and a second mask opening formed over the first deep isolation trench opening, where the first mask opening has a larger opening dimension than the second mask opening so that a shared selective etch process may be applied to simultaneously etch the first deep isolation trench opening and the first concentric shallow isolation trench opening. In other selected embodiments, the first poly isolation ring structure and the first concentric shallow isolation ring structure are simultaneously formed in the first deep isolation trench opening and the first concentric shallow isolation trench opening by sequentially depositing one or more insulating liner layers, and then depositing one or more polysilicon layers to fill the first deep isolation trench opening and the first concentric shallow isolation trench opening. In other selected embodiments, the first deep isolation trench opening and the first concentric shallow isolation trench opening are simultaneously formed in the substrate structure by forming a patterned etch mask on the substrate structure with mask openings formed over the first deep isolation trench opening and the first concentric shallow isolation trench opening, and then applying one or more deep reactive-ion etching (RIE) steps having suitable etch chemistry properties to remove exposed portions of the substrate structure to form the first deep isolation trench opening and the first concentric shallow isolation trench opening.

Although the described exemplary embodiments disclosed herein are directed to various fabrication processes and integrated circuit designs having isolation structures employing high voltage tub regions that are isolated by concentric floating deep and shallow poly structures, the present invention is not necessarily limited to the example embodiments which illustrate inventive aspects of the present invention that are applicable to a wide variety of device fabrication processes and/or structures. Thus, the particular embodiments disclosed above are illustrative only and should not be taken as limitations upon the present invention, as the invention may be modified and practiced in different but equivalent manners apparent to those skilled in the art having the benefit of the teachings herein. For example, while the various devices illustrated herein are for high voltage tubs formed with isolated n-well regions or the like, this is merely for convenience of explanation and not intended to be limiting and persons of skill in the art will understand that the principles taught herein apply to devices of either conductivity type. In addition, the well regions are described as being formed by implanting n-type dopants into a p-type upper semiconductor layer, but the inverse approach could instead be used by implanting p-type dopants into an n-type upper semiconductor layer, Accordingly, the identification of particular regions as N-type or P-type is merely by way of illustration and not limitation and opposite conductivity type regions may be substituted in order to form devices of opposite conduction type. Moreover, the thicknesses and doping concentrations of the described layers may be adjusted as required for the required application. Accordingly, the foregoing description is not intended to limit the invention to the particular form set forth, but on the contrary, is intended to cover such alternatives, modifications and equivalents as may be included within the scope of the invention as defined by the appended claims so that those skilled in the art should understand that they can make various changes, substitutions and alterations without departing from the scope of the invention in its broadest form.

One or more embodiments of the present disclosure may include features recited in the following numbered clauses:
1. An integrated circuit device, comprising: a substrate of a first conductivity type; a first epitaxial layer of a second conductivity type located on the substrate; one or more additional epitaxial layers of the first conductivity type located on the first epitaxial layer; a buried layer of the second conductivity type located in the one or more additional epitaxial layers to be adjacent to the first epitaxial layer; a central isolated region located in the one or more additional epitaxial layers to be positioned over the buried layer; one or more concentric shallow isolation ring structures positioned to surround the central isolated region and to extend down through the buried layer and into the first epitaxial layer; and a concentric deep poly isolation structure positioned to surround the central isolated region and the one or more concentric shallow isolation ring structures and to extend down through the first epitaxial layer and into the substrate; wherein the concentric deep poly isolation structure comprises one or more polysilicon layers that are shorted to the substrate.
2. The integrated circuit device of clause 1, where the buried layer extends laterally only below the central isolated region and does not extend laterally past the concentric deep poly isolation structure.
3. The integrated circuit device of clause 1, where the one or more concentric shallow isolation ring structures each comprise one or more polysilicon layers surrounded by an insulating liner layer.
4. The integrated circuit device of clause 1, where the one or more concentric shallow isolation ring structures each comprise one or more insulating layers.
5. The integrated circuit device of clause 1, where the concentric deep poly isolation structure comprises one or more polysilicon layers surrounded by an insulating liner layer except for a bottom portion which directly contacts the substrate .
6. The integrated circuit device of clause 1, where each of the one or more concentric shallow isolation ring structures is electrically connected to a separate predetermined voltage.
7. The integrated circuit device of clause 1, where the first conductivity type is p-type and where the second conductivity type is n-type.
8. An integrated circuit device, comprising: a P+ substrate; an n-type epitaxial layer located on the P+ substrate; one or more p-type epitaxial layers located on the n-type epitaxial layer; an n-type buried layer located in the one or more p-type epitaxial layers and adjacent to the n-type epitaxial layer; an isolated high voltage well region located in the one or more p-type epitaxial layers and over the n-type buried layer; a first poly isolation ring structure concentrically disposed to surround the isolated high voltage well region and to extend through the one or more p-type epitaxial layers, the n-type buried layer, the n-type epitaxial layer, and into the P+ substrate; and a first concentric shallow isolation ring structure positioned concentrically within the first poly isolation ring structure to surround the isolated high voltage well region and to extend through the one or more p-type epitaxial layers and the n-type buried layer and into the n-type epitaxial layer, wherein the first poly isolation ring structure comprises one or more polysilicon layers that are shorted to the P+ substrate.
9. The integrated semiconductor device of clause 8, further comprising a second concentric shallow isolation ring structure positioned concentrically within the first concentric shallow isolation ring structure to surround the isolated high voltage well region and to extend through the one or more p-type epitaxial layers and the n-type buried layer and into the n-type epitaxial layer.
10. The integrated semiconductor device of clause 9, wherein each of the first and second concentric shallow isolation ring structures comprises one or more polysilicon layers surrounded by an insulating liner layer.
11. The integrated semiconductor device of clause 10, wherein a first voltage is connected to the one or more polysilicon layers of the first concentric shallow isolation ring structure, and where a second voltage is connected to the one or more polysilicon layers of the second concentric shallow isolation ring structure.
12. The integrated semiconductor device of clause 9, wherein each of the first and second concentric shallow isolation ring structures comprises one or more insulating layers.
13. The integrated semiconductor device of clause 8, wherein the first poly isolation ring structure comprises one or more polysilicon layers surrounded by an insulating liner layer except for a bottom portion which directly contacts the P+ substrate.
14. The integrated semiconductor device of clause 8, wherein the first concentric shallow isolation ring structure comprises one or more polysilicon layers surrounded by an insulating liner layer.
15. The integrated semiconductor device of clause 14, wherein a first voltage is connected to the one or more polysilicon layers of the first concentric shallow isolation ring structure.
16.A method, comprising: forming a substrate structure comprising a P+ substrate, an n-type epitaxial layer located on the P+ substrate, and one or more p-type epitaxial layers located on the n-type epitaxial layer, and an implanted n-type buried layer in the one or more p-type epitaxial layers to be located adjacent to the n-type epitaxial layer; selectively etching a first deep isolation trench opening and a first concentric shallow isolation trench opening in the substrate structure that are concentrically disposed to surround an isolated high voltage well region located in an upper region of the substrate structure, where the first deep isolation trench opening extends into the substrate structure down through the one or more p-type epitaxial layers, the n-type buried layer, the n-type epitaxial layer, and into the P+ substrate, and where the first concentric shallow isolation trench opening extends into the substrate structure down through the one or more p-type epitaxial layers and the n-type buried layer and into the n-type epitaxial layer; forming a first poly isolation ring structure in the first deep isolation trench opening; forming a first concentric shallow isolation ring structure in the first concentric shallow isolation trench opening; and
   selectively implanting one or more p-type or n-type wells in the isolated high voltage well region.
17. The method of clause 16, further comprising forming a first conductive interconnect structure for electrically connecting the first concentric shallow isolation ring structure to a predetermined voltage.
18. The method of clause 16, where a single patterned etch mask is used to simultaneously selectively etch the first deep isolation trench opening and the first concentric shallow isolation trench opening, where the single patterned etch mask comprises a first mask opening formed over the first deep isolation trench opening and a second mask opening formed over the first deep isolation trench opening, where the first mask opening has a larger opening dimension than the second mask opening so that a shared selective etch process may be applied to simultaneously etch the first deep isolation trench opening and the first concentric shallow isolation trench opening.
19. The method of clause 16, where the first poly isolation ring structure and the first concentric shallow isolation ring structure are simultaneously formed in the first deep isolation trench opening and the first concentric shallow isolation trench opening by sequentially depositing one or more insulating liner layers, and then depositing one or more polysilicon layers to fill the first deep isolation trench opening and the first concentric shallow isolation trench opening.
20. The method of clause 16, where the first deep isolation trench opening and the first concentric shallow isolation trench opening are simultaneously formed in the substrate structure by forming a patterned etch mask on the substrate structure with mask openings formed over the first deep isolation trench opening and the first concentric shallow isolation trench opening, and then applying one or more deep reactive-ion etching (RIE) steps having suitable etch chemistry properties to remove exposed portions of the substrate structure to form the first deep isolation trench opening and the first concentric shallow isolation trench opening.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that includes a list of elements is not necessarily limited to those elements, but may include other elements not expressly listed or inherent to such process, method, article, or apparatus. The term "coupled," as used herein, is defined as directly or indirectly connected in an electrical or non-electrical manner.

As used herein, the term "semiconductor" is intended to include any semiconductor whether single crystal, poly-crystalline or amorphous and to include type IV semiconductors, non-type IV semiconductors, compound semiconductors as well as organic and inorganic semiconductors. Further, the terms "substrate" and "semiconductor substrate" are intended to include single crystal structures, polycrystalline structures, amorphous structures, thin film structures, layered structures (e.g., semiconductor-on-insulator (SOI) structures), and combinations thereof. For convenience of explanation and not intended to be limiting, semiconductor components and methods of fabrication are described herein for silicon semiconductors but persons of skill in the art will understand that other semiconductor materials may also be used.

As used herein, the term "floating" refers to an electrical condition where an integrated circuit structure (e.g., polysilicon structure) is not connected to voltage source or fixed reference, such as a ground voltage, and/or is not connected electrically to another non-floating (grounded) conductor.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. An integrated circuit device, comprising:
a substrate of a first conductivity type;
a first epitaxial layer of a second conductivity type located on the substrate;
one or more additional epitaxial layers of the first conductivity type located on the first epitaxial layer;
a buried layer of the second conductivity type located in the one or more additional epitaxial layers to be adjacent to the first epitaxial layer;
a central isolated region located in the one or more additional epitaxial layers to be positioned over the buried layer;
one or more concentric shallow isolation ring structures positioned to surround the central isolated region and to extend down through the buried layer and into the first epitaxial layer; and
a concentric deep poly isolation structure positioned to surround the central isolated region and the one or more concentric shallow isolation ring structures and to extend down through the first epitaxial layer and into the substrate;
wherein the concentric deep poly isolation structure comprises one or more polysilicon layers that are shorted to the substrate.

2. The integrated circuit device of claim 1, where the buried layer extends laterally only below the central isolated region and does not extend laterally past the concentric deep poly isolation structure.

3. The integrated circuit device of claim 1 or 2, where the one or more concentric shallow isolation ring structures each comprise one or more polysilicon layers surrounded by an insulating liner layer.

4. The integrated circuit device of any of the preceding claims, where the one or more concentric shallow isolation ring structures each comprise one or more insulating layers.

5. The integrated circuit device of any of the preceding claims, where the concentric deep poly isolation structure comprises one or more polysilicon layers surrounded by an insulating liner layer except for a bottom portion which directly contacts the substrate .

6. The integrated circuit device of any of the preceding claims, where each of the one or more concentric shallow isolation ring structures is electrically connected to a separate predetermined voltage.

7. The integrated circuit device of any of the preceding claims, where the first conductivity type is p-type and where the second conductivity type is n-type.

8. An integrated circuit device, comprising:
a P+ substrate;
an n-type epitaxial layer located on the P+ substrate;
one or more p-type epitaxial layers located on the n-type epitaxial layer;
an n-type buried layer located in the one or more p-type epitaxial layers and adjacent to the n-type epitaxial layer;
an isolated high voltage well region located in the one or more p-type epitaxial layers and over the n-type buried layer;
a first poly isolation ring structure concentrically disposed to surround the isolated high voltage well region and to extend through the one or more p-type epitaxial layers, the n-type buried layer, the n-type epitaxial layer, and into the P+ substrate; and
a first concentric shallow isolation ring structure positioned concentrically within the first poly isolation ring structure to surround the isolated high voltage well region and to extend through the one or more p-type epitaxial layers and the n-type buried layer and into the n-type epitaxial layer,
wherein the first poly isolation ring structure comprises one or more polysilicon layers that are shorted to the P+ substrate.

9. The integrated semiconductor device of claim 8, further comprising a second concentric shallow isolation ring structure positioned concentrically within the first concentric shallow isolation ring structure to surround the isolated high voltage well region and to extend through the one or more p-type epitaxial layers and the n-type buried layer and into the n-type epitaxial layer.

10. The integrated semiconductor device of claim 9, wherein each of the first and second concentric shallow isolation ring structures comprises one or more polysilicon layers surrounded by an insulating liner layer.

11. The integrated semiconductor device of claim 10, wherein a first voltage is connected to the one or more polysilicon layers of the first concentric shallow isolation ring structure, and where a second voltage is connected to the one or more polysilicon layers of the second concentric shallow isolation ring structure.

12. The integrated semiconductor device of any of the preceding claims 9 to 11, wherein each of the first and second concentric shallow isolation ring structures comprises one or more insulating layers.

13. The integrated semiconductor device of any of the preceding claims 8 to 12, wherein the first poly isolation ring structure comprises one or more polysilicon layers surrounded by an insulating liner layer except for a bottom portion which directly contacts the P+ substrate.

14. The integrated semiconductor device of any of the preceding claims 8 13, wherein the first concentric shallow isolation ring structure comprises one or more polysilicon layers surrounded by an insulating liner layer.

15. A method, comprising:
forming a substrate structure comprising a P+ substrate, an n-type epitaxial layer located on the P+ substrate, and one or more p-type epitaxial layers located on the n-type epitaxial layer, and an implanted n-type buried layer in the one or more p-type epitaxial layers to be located adjacent to the n-type epitaxial layer;
selectively etching a first deep isolation trench opening and a first concentric shallow isolation trench opening in the substrate structure that are concentrically disposed to surround an isolated high voltage well region located in an upper region of the substrate structure,
where the first deep isolation trench opening extends into the substrate structure down through the one or more p-type epitaxial layers, the n-type buried layer, the n-type epitaxial layer, and into the P+ substrate, and
where the first concentric shallow isolation trench opening extends into the substrate structure down through the one or more p-type epitaxial layers and the n-type buried layer and into the n-type epitaxial layer;
forming a first poly isolation ring structure in the first deep isolation trench opening;
forming a first concentric shallow isolation ring structure in the first concentric shallow isolation trench opening; and
selectively implanting one or more p-type or n-type wells in the isolated high voltage well region.
